# EUROPÄISCHE PATENTSCHRIFT

(11) **EP 2 099 266 B1**
(45) Veröffentlichungstag und Bekanntmachung des Hinweises auf die Patenterteilung: **31.10.2018**
(21) Anmeldenummer: 09002313.6
(22) Anmeldetag: 19.02.2009
(51) Int. Cl.: G01S 7/521, G10K 9/22, G10K 11/00, H05K 1/11, H01R 12/59, H05K 1/18

(54) **Ultraschallwandler mit einer flexiblen Leiterplatte**
Ultrasonic transducer with a flexible circuit board
Transducteur ultrasonore doté d'une plaquette flexible

(30) Priorität: 06.03.2008 DE 102008012913
(43) Veröffentlichungstag der Anmeldung: 09.09.2009
(73) Patentinhaber: Valeo Schalter und Sensoren GmbH, 74321 Bietigheim-Bissingen (DE)
(72) Erfinder: Brunner, Erhard, 86720 Nördingen (DE); Felber, Franz, 86681 Fünfstetten (DE)

(56) Entgegenhaltungen:
- WO-A-95/07601
- WO-A-2007/123293
- WO-A2-99/10875
- DE-A1- 19 861 112
- JP-A- 2 297 998
- US-A- 3 764 422
- US-A1- 2003 162 414

## Beschreibung

Die Erfindung betrifft ein elektrisches Bauteil oder Gerät mit einer zumindest teilweise flexiblen Leiterplatte in einem Gehäuse nach der Gattung des Hauptanspruchs.

Es ist beispielsweise aus der DE 199 04 979 A1 bekannt, dass ein elektrisches Gerät, hier ein Schalter, in einem Gehäuse eine flexible Leiterplatte aufweist, die Leiterbahnen besitzt, welche verschiedene Schaltkontakte im Gerät miteinander verbinden. Damit die Leiterbahnen der Leiterplatte auf einfache Weise im Gehäuse auch abgewinkelt werden können und so auch an unterschiedliche Gehäusebereiche geführt werden können, ist die Leiterplatte aus einem flexiblen Kunststoffmaterial hergestellt und mit den ebenfalls in ausreichender Weise auch flexiblen Kupferbahnen als Leiterbahnen versehen. Die Kupferbahnen sind hier auch an vorgegebenen Stellen als Kontaktflächen für Schaltkontakte ausgebildet.

Des Weiteren sind aus der DE 198 61 112 A1 und der WO 2007/123293 A jeweils für sich genommen tragbare elektronische Geräte bekannt, bei denen zur elektrischen Kontaktierung ein flexibler Bereich einer Leiterplatte mit Kontaktstellen aus dem Gerätegehäuse herausragt.

WO 99/10875 betrifft einen Ultraschallwandler mit einer neuartigen Anordnung der elektrischen Schaltungsanordnung sowie der Verwendung flexibler Leiterfolien zur Verbindung der elektrischen Komponenten und zur Schaffung eines neuartigen Kabelabgangs für Ultraschallsensoren.

### Darstellung der Erfindung

Die Erfindung geht von einem Ultraschallwandler zur Anbringung an Karosserieteilen eines Kraftfahrzeugs mit einer zumindest teilweise flexiblen Leiterplatte in einem Gehäuse aus, deren Leiterbahnen auch Kontaktstellen zur elektrischen Kontaktierung aufweisen. Es kann als eine Aufgabe der Erfindung angesehen werden, einen solchen Ultraschallwandler so herzustellen, dass insbesondere auch die äußeren Steckkontakte flexibel an die Anwendungsgebiete angepasst werden können und dabei eine sichere Kontaktierung gewährleistet ist.

Gemäß der Erfindung wird vorgeschlagen, dass ein flexibler und/oder starrer Bereich der Leiterplatte im Gehäuse fest angeordnet ist und ein weiterer flexibler Bereich mit Kontaktstellen zur Bildung einer äußeren Steckeranordnung in vorteilhafter Weise aus dem Gehäuse herausragt. Der flexible und/oder starre Bereich der Leiterplatte im Gehäuse ist dabei im Gehäuse fest vergossen, sodass sich hierdurch ein sicherer Halt ergibt.

Der flexible Bereich der Leiterplatte ist mit den Kontaktstellen außen am Gehäuse derart abgewinkelt, dass die Kontaktstellen als Steckerkontakte bei der Anordnung des elektrischen Bauteils oder Geräts in einer weiteren Anordnung mit korrespondierenden Steckerkontakten dienen. Der außen am Gehäuse abgewinkelte Bereich ist in einer Steckertasche fest verankert, wobei die Kontaktstellen außen fest zu liegen kommen.

Nach einer ersten Variante kommt der außen am Gehäuse abgewinkelte Bereich seitlich am Gehäuse zu liegen und nach einer zweiten Variante kommt der außen am Gehäuse abgewinkelte Bereich am hinteren Ende des Gehäuses zu liegen; möglich sind herbei auch Kombinationen beider Anordnungen.

Somit kann auf einfache Weise eine vielfältig anpassbare Steckkontaktierung mit einer sicheren Kontaktierung des elektrischen Bauteils oder Geräts gebildet werden und es müssen nicht mehr, wie beim Stand der Technik üblich, an den Leiterplatten unterschiedliche Stecker eingepresst, angelötet oder mit sonstigen aufwändigen Herstellungsschritten angebracht werden.

An der Steckeranordnung am nicht umspritzten oder nicht umgossenen Ende der Leiterplatte sind somit über sogenannte Kontaktpads die Kontaktstellen gebildet, die den eigentlichen Stecker bilden. Je nach gewünschter Ausführung kann dieser Stecker dann nach links oder rechts umgelegt werden und in der Steckertasche verrastet werden.

Es ist somit weitgehend ein Einheitstyp des elektrischen Bauteils oder Geräts für verschiedene Steckerabgänge herstellbar, was zumindest eine Reduzierung der Typenvielfalt bedeutet und ein zusätzlich anzubringendes Steckerteil ist nicht mehr notwendig, sodass hierdurch auch Kosten- und Montagezeiteinsparungen möglich sind. Weiterhin sind Investeinsparungen im Herstellungsprozess und Qualitätsverbesserung durch eine Verringerung der Fehler bei der Anbringung eines zusätzlichen Teils möglich, da eine elektrische Schnittstelle weniger vorhanden ist und darüber hinaus auch eine Reduzierung von Gewicht und Bauraumbedarf mit der Erfindung erreichbar ist.

Ausführungsbeispiele der Erfindung werden anhand der Figuren der Zeichnung erläutert. Es zeigen:
Figur 1 eine Ansicht auf einen Ultraschallwandler ohne Gehäuse mit einer flexiblen Leiterplatte,
Figur 2a und 2b Ansichten auf den Ultraschallwandler nach der Figur 1 im vergossenen Zustand mit einem herausragenden flexiblen Bereich der Leiterplatte zur Herstellung einer Steckeranordnung am hinteren Teil des Gehäuses,
Figur 3a und 3b Ansichten auf den Ultraschallwandler nach der Figur 1 im vergossenen Zustand mit einem herausragenden flexiblen Bereich zur Herstellung einer Steckeranordnung am seitlichen Teil des Gehäuses und
Figur 4 eine Ansicht auf den Ultraschallwandlernach der Figur 1 im vergossenen Zustand mit einem herausragenden flexiblen Bereich zur Herstellung einer Steckeranordnung wahlweise am hinteren oder seitlichen Teil des Gehäuses.

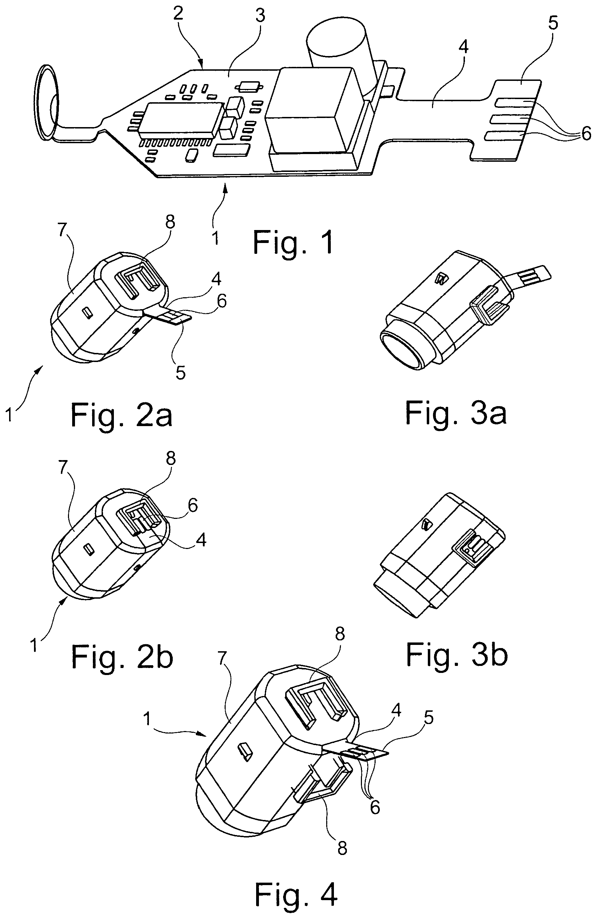

In Figur 1 ist in eine Ansicht auf einen Ultraschallwandler 1 zur Anbringung an Karosserieteilen eines Kraftfahrzeugs gezeigt. Der Ultraschallwandler 1 weist eine Leiterplatte 2 auf, die hier aus einem relativ starren Bereich 3, auf dem elektronische Bauteile angeordnet sind, und einem flexiblen Bereich 4 besteht. Der flexible Bereich 4 trägt am Ende eine Steckeranordnung 5 mit Kontaktpads, die Kontaktstellen 6 bilden.

Aus Figur 2a und Figur 2b ist zu entnehmen, dass ein Gehäuse 7 die Leiterplatte 2 umschließt, beispielsweise aus einer Vergussmasse, und der flexible Bereich 4 mit der Steckeranordnung 5 aus dem Gehäuse 7 herausragt. Am hinteren Ende des Gehäuses 7 befindet sich eine Steckertasche 8, in die nach der Figur 2b der flexible Bereich 4 zur Verrastung einführbar ist. Der Ultraschallwandlerl mit dem Gehäuse 7 kann nun in eine entsprechende Steckeraufnahme eingeführt werden und dabei ein sicherer elektrischer Kontakt über die Kontaktstellen 6 hergestellt werden.

Aus Figur 3a und Figur 3b ist zu entnehmen, dass der flexible Bereich 4 mit der Steckeranordnung 5 ebenfalls aus dem Gehäuse 7 herausragt. Hier befindet sich jedoch seitlich am Gehäuse 7 die Steckertasche 8, in die nach der Figur 3b der flexible Bereich 4 zur Verrastung einführbar ist. Der Ultraschallwandler1 mit dem Gehäuse 7 kann nun auch hiermit in eine entsprechende Steckeraufnahme eingeführt werden und dabei ein sicherer elektrischer Kontakt über die Kontaktstellen 6 hergestellt werden.

Die Darstellung nach Figur 4 zeigt noch, wie der flexible Bereich 4 mit der Steckeranordnung 5 entweder in eine seitlich oder hinten am Gehäuse 7 liegende Steckertasche 8 eingeführt werden kann.

## Patentansprüche

1. Ultraschallwandler (1) zur Anbringung an Karosserieteilen eines Kraftfahrzeugs mit einer zumindest teilweise flexiblen Leiterplatte (2) in einem Gehäuse (7), deren Leiterbahnen auch Kontaktstellen zur elektrischen Kontaktierung aufweisen, wobei ein flexibler und/oder starrer Bereich (3) der Leiterplatte (2) im Gehäuse (7) fest angeordnet und im Gehäuse (7) vergossen ist und ein flexibler Bereich (4) mit Kontaktstellen (6) aus dem Gehäuse (7) herausragt, **dadurch gekennzeichnet, dass** der flexible Bereich (4) der Leiterplatte (2) mit den Kontaktstellen (6) außen am Gehäuse (7) derart abgewinkelt ist, dass die Kontaktstellen (6) als Steckerkontakte bei der Anordnung des Ultraschallwandlers (1) in einer weiteren Anordnung mit korrespondierenden Steckerkontakten dienen, wobei der außen am Gehäuse (7) abgewinkelte Bereich (4) in einer Steckertasche (8) fest verankert ist, und wobei die Kontaktstellen (6) außen fest zu liegen kommen.

## Claims

1. Ultrasonic transducer (1) for attachment to body parts of a motor vehicle, having an at least partially flexible circuit board (2) in a housing (7), the conductor tracks of which circuit board also have contact points for electrical contacting purposes, wherein a flexible and/or rigid region (3) of the circuit board (2) is arranged fixedly in the housing (7) and is encapsulated in the housing (7), and a flexible region (4) with contact points (6) projects out of the housing (7), **characterized in that** the flexible region (4) of the circuit board (2) with the contact points (6) is angled on the outside of the housing (7) such that the contact points (6) serve as plug contacts when the ultrasonic transducer (1) is arranged in a further arrangement with corresponding plug contacts, wherein the region (4) angled on the outside of the housing (7) is fixedly anchored in a plug pocket (8), and wherein the contact points (6) come to lie in a fixed position on the outside.

## Revendications

1. Transducteur ultrasonore (1) destiné à être monté sur des pièces de carrosserie d'un véhicule automobile, comprenant une carte à circuits imprimés (2) au moins en partie flexible dans un boîtier (7), dont les pistes conductrices présentent également des zones de contact en vue d'un contact électrique, une région flexible et/ou rigide (3) de la carte à circuits imprimés (2) étant disposée fixement dans le boîtier (7) et étant moulée dans le boîtier (7) et une région flexible (4) avec des zones de contact (6) faisant saillie hors du boîtier (7), **caractérisé en ce que** la région flexible (4) de la carte à circuits imprimés (2) avec les zones de contact (6) est coudée à l'extérieur au niveau du boîtier (7) de telle sorte que les zones de contact (6) servent de contacts enfichables lors de l'agencement du transducteur ultrasonore (1) dans un autre agencement avec des contacts enfichables correspondants, la région (4) coudée à l'extérieur au niveau du boîtier (7) étant ancrée fixement dans un logement de connecteur (8) et les zones de contact (6) venant se placer fixement à l'extérieur.
